(19) Europäisches Patentamt
European Patent Office
Office européen des brevets

(11) **EP 2 230 689 A1**

(12) **EUROPÄISCHE PATENTANMELDUNG**

(43) Veröffentlichungstag:
**22.09.2010 Patentblatt 2010/38**

(51) Int Cl.:
*H01L 23/62* (2006.01)      *H01L 23/373* (2006.01)
*H01L 25/07* (2006.01)

(21) Anmeldenummer: **09155617.5**

(22) Anmeldetag: **19.03.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**
Benannte Erstreckungsstaaten:
**AL BA RS**

(71) Anmelder: **Siemens Aktiengesellschaft**
**80333 München (DE)**

(72) Erfinder:
• **Kreutzer, Rainer**
  **92637, Weiden (DE)**
• **Benning, David**
  **92245, Kümmersbruck (DE)**
• **Jonas, Stephan**
  **92431, Neunburg (DE)**
• **Schaller, Karl-Heinz**
  **92289, Ursensollen (DE)**

(54) **Kurzschlusssicheres Halbleitermodul**

(57)      Ein Halbleitermodul (2) wird angegeben, welches in Verbindung mit einer vorzuschaltenden Überstromschutzeinrichtung (3) mit erhöhter Sicherheit betreibbar ist. Danach umfasst das Halbleitermodul (2) ein Gehäuse (4), in welchem ein isolierendes Substrat (21) aufgenommen ist. Weiterhin umfasst das Halbleitermodul (2) mindestens ein Halbleiterbauelement (31), welches mit einer Unterseite (32) stoffschlüssig mit dem Substrat verbunden ist. Zudem umfasst das Halbleitermodul (2) mindestens ein elektrisches Verbindungselement (34) zur elektrischen Kontaktierung des Halbleiterbauelements (31), welches stoffschlüssig und elektrisch leitend einerseits mit einer Oberseite (33) des Halbleiterbauelements (31) und andererseits mit einer Leiterbahn (26) verbunden ist. Das Verbindungselement (34) bzw. die Verbindungselemente (34) weisen insgesamt eine minimale Querschnittsfläche ($A_{min}$) auf, die ausreichend groß dimensioniert ist, dass ein Schmelzintegral ($I_S^2 t$) des Verbindungselements (34) bzw. der Verbindungselemente (34) mindestens gleich groß ist, wie ein Durchlassintegral ($I_D^2 t$) der bestimmungsgemäß dem Halbleitermodul (2) vorzuschaltenden Überstromschutzeinrichtung (3).

FIG 3

**Beschreibung**

Die Erfindung bezieht sich auf ein Halbleitermodul mit einem Gehäuse, mit einem darin aufgenommenen isolierenden Substrat, mit mindestens einem Halbleiterbauelement, welches mit einer Unterseite stoffschlüssig mit dem Substrat verbunden ist, sowie mit mindestens einem elektrischen Verbindungselement, welches zur elektrischen Kontaktierung stoffschlüssig und elektrisch leitend einerseits mit einer Oberseite des Halbleiterbauelements und andererseits mit einer Leiterbahn verbunden ist. Die Erfindung bezieht sich weiterhin auf eine Schaltungsbaugruppe mit einem solchen Halbleitermodul und einem vorgeschalteten Leistungsschutzschalter.

Hableitermodule der oben genannten Art werden insbesondere zum Schalten und Steuern von elektrischen Leistungen im kW-Bereich eingesetzt, z.B. als Leistungsschalter in einem Umrichter. Bei dem Halbleiterbauelement handelt es sich insbesondere um einen Thyristor, einen Transistor (IGBT, MOSFET, etc.) oder eine Diode.

Als Substrat wird häufig eine Keramikplatte eingesetzt. Die stoffschlüssige Verbindung des Halbleiterbauelements mit dem Substrat dient zum Einen zur mechanischen Fixierung des Halbleiterbauelements im Gehäuse. Zum Anderen erfüllt diese Verbindung aber auch eine wichtige Funktion für die Entwärmung des Halbleiterbauelements. Häufig, aber nicht zwangsweise ist das Halbleiterbauelement sowohl oberseitig als auch unterseitig elektrisch kontaktiert. In diesem Fall ist dem Substrat und dem Halbleiterbauelement mindestens eine Leiterbahn zwischengeordnet, so dass das Halbleiterbauelement mittelbar über diese Leiterbahn mit dem Substrat verbunden ist. Als Verbindungselement werden häufig sogenannte Bond-Drähte eingesetzt.

Einem Halbleitermodul der oben genannten Art ist im Rahmen einer elektronischen Schaltung häufig eine Schutzeinrichtung vorgeschaltet, die das Halbleitermodul bei einem Überstrom von der Stromversorgung trennt. Als Überstromschutzeinrichtung wird heute in der Regel ein Leistungsschutzschalter herangezogen. Ein solcher Leistungsschutzschalter hat den Vorteil, dass er nach einem Fehlerfall wieder einschaltbar ist. Herkömmliche Leistungsschutzschalter weisen aber nachteiligerweise eine vergleichsweise große Ansprechzeit auf, schalten also vergleichsweise langsam ab.

Ein Halbleitermodul und der zugeordnete Leistungsschutzschalter werden üblicherweise nach Maßgabe des Nennstroms des Halbleitermoduls aufeinander abgestimmt. Gewöhnlich wird beispielsweise der Gesamtquerschnitt der als Verbindungselement vorgesehenen Bond-Drähte derart dimensioniert, dass die Bond-Drähte während einer der Abschaltzeit des Leistungsschutzschalters entsprechenden Zeitspanne dem 7,2-fachen Nennstrom standhalten.

Bei einem im Normalbetrieb einer solchen Schaltungsbaugruppe vorkommenden Überlastfall reicht der durch den Leistungsschutzschalter vermittelte Schutz normalerweise aus, um eine Beschädigung des Halbleitermoduls zu vermeiden. Im Falle eines Kurzschlusses reagiert ein Leistungsschutzschalter jedoch häufig zu träge, um eine Zerstörung des Halbleitermoduls zu verhindern. In diesem Fall kann es insbesondere vorkommen, dass die Bond-Drähte unter Bildung eines Lichtbogens durchschmelzen. Unter Wirkung des Lichtbogens kann dann im Gehäuse des Halbleitermoduls ein hoher Überdruck entstehen, der unter ungünstigen Umständen zu einer Explosion des Halbleitermoduls führen kann. Eine solche Explosion birgt zum Einen eine Verletzungsgefahr durch umherfliegende Gehäuseteile. Zum Anderen besteht aufgrund der Zerstörung des Gehäuses ein gewisses Risiko, dass spannungsführende Bauteile - zumindest bis zum Ansprechen des Leistungsschutzschalters - offenliegen.

Der Erfindung liegt die Aufgabe zugrunde, ein Halbleitermodul anzugeben, welches in Verbindung mit einer vorzuschaltenden Überstromschutzeinrichtung mit erhöhter Sicherheit betreibbar ist. Weiterhin ist es Aufgabe der Erfindung, eine mit erhöhter Sicherheit betreibbare Schaltungsbaugruppe mit einem solchem Halbleitermodul sowie einer vorgeschalteten Überstromschutzeinrichtung in Form eines Leistungsschutzschalters anzugeben.

Bezüglich des Halbleitermoduls wird diese Aufgabe erfindungsgemäß gelöst durch die Merkmale des Anspruchs 1.

Danach umfasst das Halbleitermodul ein Gehäuse, in welchem ein elektrisch isolierendes Substrat aufgenommen ist.

Weiterhin umfasst das Halbleitermodul mindestens ein Halbleiterbauelement, welches mit einer Unterseite stoffschlüssig auf dem Substrat aufgebracht ist. Zudem umfasst das Halbleitermodul mindestens ein Verbindungselement zur elektrischen Kontaktierung des Halbleiterbauelements, welches stoffschlüssig und elektrisch leitend einerseits mit einer (insbesondere zur Unterseite entgegengesetzten) Oberseite des Halbleiterbauelements und andererseits mit einer Leiterbahn verbunden ist. In bevorzugter Ausgestaltung der Erfindung ist diese Leiterbahn ebenfalls auf dem Substrat aufgebracht. Das Verbindungselement bzw. die Verbindungselemente weisen insgesamt eine minimale Querschnittsfläche auf, die ausreichend groß dimensioniert ist, dass das dem Verbindungselement bzw. den Verbindungselementen zugeordnete Schmelzintegral mindestens genauso groß ist wie das Durchlassintegral einer dem Halbleitermodul bestimmungsgemäß vorzuschaltenden Überstromschutzeinrichtung.

Die minimale Querschnittsfläche eines einzelnen einsträngigen Verbindungselements ist gegeben durch die Querschnittsfläche dieses Verbindungselements an seiner engsten Stelle zwischen einem Kontaktpunkt des Verbindungselements mit der Oberseite des Halbleitermoduls und dem unmittelbar benachbarten Kontaktpunkt des Verbindungselements mit der Leiterbahn. Sind mehrere einsträngige Verbindungselemente oder ein sich in mehrere Einzelstränge verzweigendes Verbindungselement vorgesehen, so ist die relevante minimale Querschnittsfläche gegeben durch die Summe der einzelnen minimalen Querschnittsflächen jedes einsträngigen Verbindungselements bzw. Einzelstrangs. Die relevante minimale Querschnittsfläche ist nachfolgend auch als Stromtragquerschnitt $A_{min}$ bezeichnet.

Das (absolute) Schmelzintegral, im Folgenden mit $I_S^2t$ gekennzeichnet, ist gegeben durch das zeitliche Integral der quadrierten Gesamtstromstärke $I_S$ des durch das Verbindungselement bzw. die Verbindungselemente fließenden Stroms, das gerade zum Durchschmelzen des Verbindungselements bzw. mindestens eines Verbindungselementes führt:

$$I_S^2t \; = \; \int_0^{t_s} I_S^2 \; \cdot \; dt \qquad\qquad\qquad \text{GLG} \; 1$$

Das Schmelzintegral ist eine konstante Kenngröße des Halbleitermoduls, die experimentell bestimmbar ist. Die mit dem Einsetzen des Schmelzstromes beginnende Schmelzzeitspanne $[0,t_S]$ ist dabei abhängig von dem - ggf. zeitlich variierenden - Betrag der im Experiment erzeugten Gesamtstromstärke. Die Gesamtstromstärke ist für die experimentelle Bestimmung des Schmelzintegrals ausreichend hoch anzusetzen (z.B. auf das 10-fache des Nennstroms des Halbleitermoduls), so dass die Wärmeableitung aus dem oder jedem Verbindungselement während der Schmelzzeitspanne vernachlässigt werden kann. In diesem Fall ist das Schmelzintegral proportional zu der aufgrund des Stromflusses während der Schmelzzeitspanne in dem Verbindungselement bzw. den Verbindungselementen deponierten Energie.

Anstelle des absoluten Schmelzintegrals $I_S^2t$ wird im Folgenden das - mathematisch vollständig äquivalente -spezifische Schmelzintegral $J_S^2t$ mit

$$J_S^2t \; = \; \frac{I_S^2t}{A_{min}^2} \; = \; \frac{1}{A_{min}^2} \; \cdot \; \int_0^{t_s} I_S^2 \; \cdot \; dt \qquad\qquad \text{GLG} \; 2$$

verwendet. Die Größe $J_S$ steht in GLG 2 für die mittlere Stromdichte, die während der Schmelzzeitspanne $[0,t_S]$ im Bereich des Stromtragquerschnitts $A_{min}$ des Verbindungselements bzw. der Verbindungselemente auftritt. Das spezifische Schmelzintegral $J_S^2t$ ist eine materialspezifische Konstante.

Das Durchlassintegral, im Folgenden mit $I_D^2t$ gekennzeichnet, und häufig auch als Durchlassenergie bezeichnet, ist gegeben durch das zeitliche Integral über die Stromstärke $I_D^2$ des die Überstromschutzeinrichtung während einer Auslösezeitspanne $[0,t_A]$ durchfließenden Stroms:

$$I_D^2t \; = \; \int_0^{t_A} I_D^2 \; \cdot \; dt \qquad\qquad\qquad \text{GLG} \; 3$$

Das Durchlassintegral ist eine konstante Kenngröße der Überstromschutzeinrichtung, die wiederum experimentell bestimmbar ist. Die Länge der mit dem Einsetzen des Durchlassstroms beginnenden Auslösezeitspanne $[0,t_A]$ hängt von dem - gegebenenfalls zeitlich variierenden - Betrag der Stromstärke $I_D$ ab. In diesem Experiment ist die Stromstärke des Durchlassstroms derart groß zu dimensionieren (z.B. auf das 10-fache des Nennstroms der Überstromschutzeinrichtung), dass die Auslöseschwelle der Überstromschutzeinrichtung dauerhaft überschritten wird. In diesem Fall ist das Durchlassintegral proportional zu der elektrischen Energie, die von der Überstromschutzeinrichtung innerhalb der Auslösezeitspanne "durchgelassen" wird.

Die erfindungsgemäße Dimensionierungsvorschrift, wonach das dem Verbindungselement bzw. den Verbindungselementen zugeordnete Schmelzintegral mindestens genauso groß zu wählen ist wie das Durchlassintegral der dem Halbleitermodul bestimmungsgemäß vorzuschaltenden Überstromschutzeinrichtung, kann äquivalentermaßen mathematisch ausgedrückt werden durch:

$$I_S^2 t \geq I_D^2 t \qquad\qquad\qquad\qquad\qquad\qquad \text{GLG 4}$$

oder

$$J_S^2 t \geq \frac{I_D^2 t}{A_{min}^2} \qquad\qquad\qquad\qquad\qquad\qquad \text{GLG 5.}$$

Aus GLG 5 ergibt sich für die Dimensionierung des Stromtragquerschnitts $A_{min}$ die Vorschrift

$$A_{min} \geq \sqrt{\frac{I_D^2 t}{J_S^2 t}} \qquad\qquad\qquad\qquad\qquad\qquad \text{GLG 6.}$$

Bei Dimensionierung des Stromtragquerschnitts gemäß GLG 6 ist im Regelfall davon auszugehen, dass auch im Kurzschlussfall kein Verbindungselement durchschmilzt. Dies verhindert vorteilhafterweise auch im Kurzschlussfall die Bildung eines Lichtbogens und unterbindet somit die Gefahr einer Beschädigung oder sogar explosionsartigen Zerstörung des Modulgehäuses. Das erfindungsgemäß ausgelegt Halbleitermodul kann daher bei Vorschaltung einer herkömmlichen Überstromschutzeinrichtung, insbesondere eines herkömmlichen Überstromschutzschalters ohne zusätzliche Sicherungsmaßnahmen sicher eingesetzt werden.

In bevorzugter Ausführung der Erfindung ist der Stromtragquerschnitt um einen Sicherheitsfaktor F gegenüber dem sich aus GLG 6 ergebenden Mindestwert überdimensioniert:

$$A_{min} = \sqrt{F \cdot \frac{I_D^2 t}{J_S^2 t}} \qquad\qquad\qquad\qquad\qquad\qquad \text{GLG 7.}$$

Dieser Sicherheitsfaktor F beträgt vorzugsweise mindestens 1,1, bevorzugt zwischen 1,1 und 1,5.

In einer vorteilhaften Ausführungsform der Erfindung sind die durch die stoffschlüssige Verbindungen des oder jeden Verbindungselements mit dem Halbleiterbauelement bzw. der Leiterbahn gebildeten Kontaktflächen derart ausgeführt, dass sie der im Kurzschlussfall wirkenden Abhebekraft sicher standhalten. Hierdurch wird die Bildung eines Lichtbogens infolge eines sich lösenden Verbindungselements ausgeschlossen und somit die Gefahr der Gehäuseexplosion weiter reduziert. Die Abhebekraft ist maßgeblich auf die sogenannte Stromengekraft (oder Holmsche Engekraft) zurückzuführen. Diese beruht auf einer magnetischen Abstoßung, die durch die im Bereich der Kontaktflächen stark zusammengeschnürten Strombahnen hervorgerufen wird. Die Größe der Abhebekraft hängt dabei zum Einen proportional von der quadrierten Stromstärke des über die Kontaktfläche geleiteten Stroms ab. Zum Anderen wird die Größe der Abhebekraft durch die Stärke der Einschnürung der Strombahnen, und die hiermit verbundene Erhöhung der Stromdichte an der Kontaktfläche beeinflusst.

Um ein Abheben des Verbindungselements bzw. eines der Verbindungselemente im Kurzschlussfall auszuschließen, ist die oder jede Kontaktfläche insbesondere derart groß dimensioniert, dass die Abhebekraft $F_A$, die unter Berücksichtigung der im Kurzschlussfall für diese Kontaktfläche zu erwartenden Maximalstromstärke $I_F$ gemäß

$$F_A[N] \approx 0{,}5 \cdot I_F^2[kA] \qquad\qquad\qquad\qquad\qquad\qquad \text{GLG 8}$$

abschätzbar ist, die Abreißkraft des Verbindungselements an der Kontaktfläche unterschreitet, insbesondere um mindestens 10% ihres Wertes unterschreitet. Bevorzugt ist die Abhebekraft auf weniger als ein Zehntel der Abreißkraft erniedrigt. Die Abreißkraft ist diejenige Kraft, die aufzubringen ist, um die stoffschlüssige Verbindung der Kontaktfläche zu lösen.

Bevorzugt weist das Halbleitermodul mehrere Verbindungselemente auf, die leitungstechnisch parallel zueinander von der Leiterbahn zur Oberseite des Halbleiterbauelements geführt sind. Durch diese Parallelisierung wird die Stromstärke in jedem einzelnen Verbindungselement reduziert, wodurch sowohl die thermische Belastung des einzelnen Verbindungselements als auch die in den zugehörigen Kontaktflächen wirkende Abhebekraft reduziert werden.

Um die Abhebekraft weiter zu reduzieren, weist das oder jedes Verbindungselement in einer weiteren vorteilhaften Ausführungsform der Erfindung mehrere Kontaktflächen auf, mit denen es jeweils stoffschlüssig mit der Oberseite des Halbleiterbauelements verbunden ist. Zusätzlich oder alternativ hierzu ist das oder jedes Verbindungselement aus demselben Grund vorzugsweise mit mehreren Kontaktflächen an der Leiterbahn angebunden. Durch die stoffschlüssige Anbindung des oder jedes Verbindungselements über mehrere distinkte Kontaktflächen wird - neben einer Vergrößerung der Gesamtkontaktfläche - auch eine erhöhte Sicherheit gegenüber Produktionsfehlern erzielt, zumal im Falle einer sich fehlerhaft lösenden Kontaktfläche die vollständige Ablösung des betroffenen Verbindungselements durch die oder jede weitere Kontaktfläche verhindert wird.

In alternativer Ausführung ist das Verbindungselement nur über eine einzige Kontaktfläche mit der Oberseite des Halbleiterbauelements verbunden, die sich aber über die gesamte Oberseite des Halbleiterbauelements oder zumindest über einen wesentlichen Teil derselben erstreckt. Die flächige Anbindung des Verbindungselements an die Oberseite des Halbleiterbauelements unterstützt hierbei in einem vorteilhaften Nebeneffekt in effektiver Weise auch die Entwärmung des Halbleiterbauelements an dessen Oberseite.

In bevorzugter Ausgestaltung der Erfindung ist das oder jedes Verbindungselement als Bandleiter ausgeführt, welches einerseits mit einer Vielzahl von Kontaktflächen auf dem Halbleiterbauelement aufgebracht ist, und andererseits mit mindestens einer Kontaktfläche auf der Leiterbahn aufgebracht ist. Ein solcher Bandleiter ist bevorzugt mittels mehrerer distinkter Kontaktflächen mit der Oberseite des Halbleiterbauelements verbunden, die in Längsausdehnung des Bandes dicht aneinandergereiht sind, wobei sich jede Kontaktfläche bevorzugt jeweils zumindest im Wesentlichen über die gesamte Breite des Bandes erstreckt.

In alternativer Ausführung ist das Verbindungselement im Wesentlichen nach Art einer - bevorzugt mehrarmigen -Tellerfeder gestaltet, die mit einer zentralen Kontaktplatte auf der Oberseite des Halbleiterbauelements aufliegt. Das derart gestaltete Verbindungselement ist vorteilhafterweise senkrecht zur Flächenausdehnung der Oberseite elastisch verformbar. Das Verbindungselement kann hierdurch insbesondere eine thermisch bedingte Ausdehnung des Halbleitermoduls oder Teilen des Halbleitermoduls bei nur geringer mechanischer Beanspruchung der Kontaktflächen ausgleichen, wodurch einem frühen Verschleiß der Kontaktflächen vorgebeugt wird.

In bevorzugter Ausführungsform umfasst das tellerfederartige Verbindungselement eine zentrale Kontaktplatte, mit der es auf der Oberseite des Halbleiterbauelements aufliegt, sowie mehrere Verbindungsarme, die sich von der Kontaktplatte aus zu der Leiterbahn erstrecken. Insbesondere weist das Verbindungselement drei Verbindungsarme auf, die etwa rechtwinklig auseinanderlaufen. Die zugehörige Leiterbahn umgibt den Auflagebereich des Halbleiterbauelements von drei Seiten.

Ferner können aber auch Bond-Drähte als Verbindungselemente eingesetzt werden.

In bevorzugter Ausgestaltung der Erfindung ist das Halbleiterbauelement durch einen Leistungshalbleiter, insbesondere einen Thyristor oder einen IGBT, gebildet. Das oder jedes Verbindungselement besteht zweckmäßigerweise aus Aluminiumdraht oder -blech. Bei Bond-Drähten ist alternativ dazu auch Golddraht vorgesehen. Bei gelöteten Verbindungselementen ist alternativ dazu auch Kupfer oder ein Eisen-Nickel-Kern ("Invar"), der beidseitig mit Kupfer überzogen ist, vorgesehen.

Ein Verbindungselement aus einer Eisen-Nickel-Legierung weist ein besonders vorteilhaftes Wärmeausdehnungsverhalten auf. Vorzugsweise ist das oder jedes Verbindungselement mit der Oberseite des Halbleiterbauelements und/oder der Leiterbahn verschweißt oder versintert. Ebenso ist das Halbleiterbauelement an seiner Unterseite vorzugsweise mit dem Substrat oder einer darauf aufgebrachten Leiterbahn verschweißt oder versintert. Schweiß- und Sinterverbindungen werden aufgrund ihrer besonders guten Temperaturbeständigkeit bevorzugt. Ferner kann jede dieser Stoffschlussverbindungen aber auch durch Löten oder Kleben mit einem leitfähigen Kleber realisiert sein.

Bezüglich der Schaltungsbaugruppe wird oben genannte Aufgabe erfindungsgemäß gelöst durch die Merkmale des Anspruchs 8. Danach umfasst die Schaltungsbaugruppe ein Halbleitermodul der vorstehend genannten Art sowie als zugeordnete Überstromschutzeinrichtung einen vorgeschalteten Leistungsschutzschalter. Das dem Leistungsschutzschalter zugeordnete Durchlassintegral und das Schmelzintegral des Halbleitermoduls sind hierbei - durch entsprechende Dimensionierung des Stromquerschnitts des Verbindungselements bzw. der Verbindungselemente - auf die im Zusammenhang mit dem Anspruch 1 vorstehend beschriebene Weise aufeinander abgestimmt.

Nachfolgend werden Ausführungsbeispiele der Erfindung anhand einer Zeichnung näher erläutert. Darin zeigen:

FIG 1    in einer schematischen Seitenansicht eine Schaltungs- baugruppe mit einem eine Schalteinrichtung umfassen- den Halbleitermodul und einem diesem als Überstrom- schutzeinrichtung vorgeschalteten Leistungsschutz- schalter,

FIG 2    in vergrößerter Detailansicht die Schalteinrichtung aus FIG 1,

FIG 3    in einer Draufsicht die Schalteinrichtung gemäß FIG 1,

FIG 4    in Darstellung gemäß FIG 3 die Schalteinrichtung in einer zweiten Ausführungsform,

FIG 5    in einem Schnitt V-V gemäß FIG 4 die dortige Schalt- einrichtung, und

FIG 6    in Darstellung gemäß FIG 3 die Schalteinrichtung in einer dritten Ausführungsform.

Einander entsprechende Teile und Größen sind in allen Figuren stets mit den gleichen Bezugszeichen versehen.

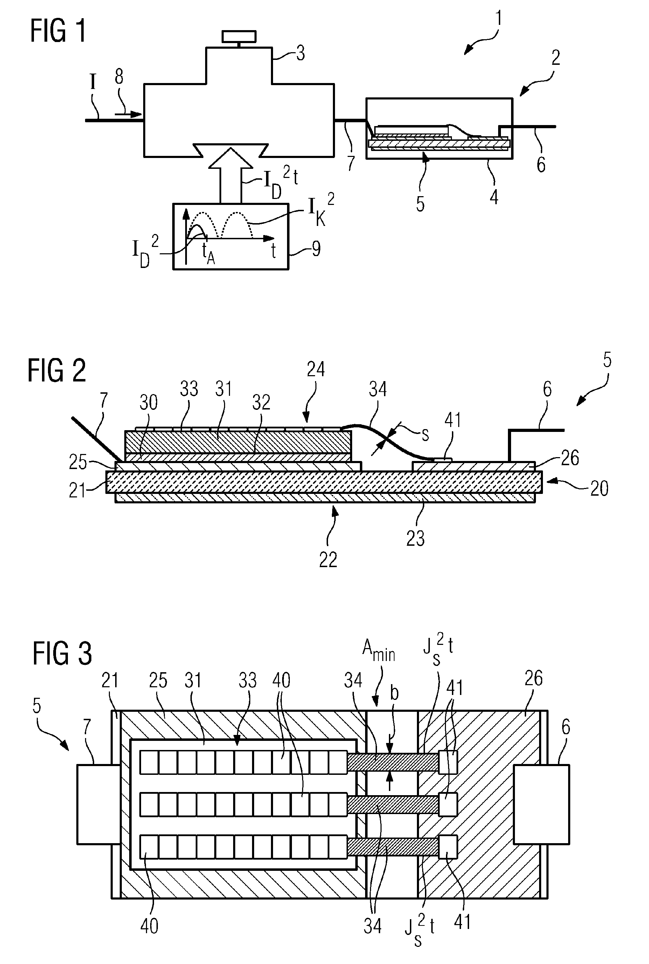

FIG 1 zeigt in einer grob schematisch vereinfachten Darstellung eine Schaltungsbaugruppe 1, die ein Halbleitermodul 2 sowie einen als Überstromschutzeinrichtung wirkenden Leistungsschutzschalter 3 umfasst.

Das Halbleitermodul 2 dient zum elektronischen Schalten eines hier nicht dargestellten Verbrauchers, beispielsweise eines Elektromotors. Bei dem Halbleitermodul 2 handelt es sich insbesondere um einen Leistungsschalter eines elektronischen Umrichters. Das Halbleitermodul 2 umfasst ein Gehäuse 4, in welchem eine Schalteinrichtung 5 aufgenommen ist. Die Schalteinrichtung 5 steht einerseits über eine aus dem Gehäuse 4 herausgeführten Stromschiene 6 (in der Darstellung rechts) mit dem Verbraucher elektrisch leitend in Verbindung, andererseits steht sie über eine ebenfalls aus dem Gehäuse herausgeführten Stromschiene 7 mit dem Leistungsschutzschalter 3 elektrisch leitend in Verbindung. Der Leistungsschutzschalter 3 ist in technischer Stromrichtung (durch einen Pfeil 8 gekennzeichnet) dem Halbleitermodul 2 bzw. der Schalteinrichtung 5 zum Schutz vor Überlast vorgeschaltet.

Der Leistungsschutzschalter 3 ist für einen Nennstrom von 12 A, sowie eine Spannung von 690 V ausgelegt und weist hier ein Durchlassintegral $I_D^2t$ von 75 000 $A^2S$ auf. Die Bedeutung des Durchlassintegrals $I_D^2t$ ist anhand eines Inset-Diagramms 9, welches dem Leistungsschutzschalter 3 zugeordnet ist, erläutert. Dieses zeigt, aufgetragen gegen die Zeit t, den Verlauf der quadrierten Kurzschlussstromstärke $I_K^2$ (dargestellt durch eine gepunktete Linie) im Vergleich mit der quadrierten Durchlassstromstärke $I_D^2$ (dargestellt durch eine durchgezogene Linie). Die Kurzschlussstromstärke $I_K$ ist diejenige prospektive (fiktive) Stromstärke, die das Halbleitermodul 2 im Kurzschlussfall in Abwesenheit des Leistungsschutzschalters 3 aufnehmen würde. Die Durchlassstromstärke $I_D$ ist dagegen diejenige Stromstärke, die im Kurzschlussfall aufgrund der Auslösung des Leistungsschutzschalters 3 tatsächlich durch diesen und das nachgeschaltete Halbleitermodul 2 fließt. Das Durchlassintegral $I_D^2t$ gibt anschaulich die Größe der unter der Verlaufskurve der quadrierten Durchlassstromstärke $I_D^2$ aufgespannten Fläche wieder.

In FIG 2 ist die Schalteinrichtung 5 gemäß FIG 1 vergrößert dargestellt. In der hier dargestellten ersten Ausführungsform umfasst die Schalteinrichtung 5 einen Schaltungsträger 20, der wiederum eine im Wesentlichen rechteckige dünne, elektrisch isolierende Keramikplatte 21, hier aus Aluminiumoxid, umfasst. Auf einer im Folgenden als Unterseite 22 bezeichneten Flachseite der Keramikplatte 21 (in der Darstellung unten) ist mittels sogenannter "Direct Copper Bonding (DCB)"-Technologie eine Kupferschicht 23 auf diese aufgebracht. Die Kupferschicht 23 dient insbesondere zur thermischen Anbindung an eine Kühleinrichtung.

Auf ihrer zur Unterseite 22 entgegengesetzten Oberseite 24 sind - wiederum mittels DCB - zwei jeweils im Wesentlichen rechteckige (FIG 3) Leiterbahnen 25 bzw. 26 auf die Keramikplatte 21 aufgebracht. Die Leiterbahnen 25 und 26 sind nebeneinander und zueinander beabstandet, somit stromtechnisch getrennt, angeordnet.

Auf die Leiterbahn 25 ist mittels einer Lotschicht 30 ein Halbleiterbauelement 31, hier ein sogenannter IGBT, aufgelötet. Die Lotschicht 30 stellt dabei über die gesamte Unterseite 32 des IGBTs (die seiner der Kollektorseite entspricht) eine elektrisch leitende, stoffschlüssige Verbindung zur Leiterbahn 25 her.

Auf die Oberseite 33 des Halbleiterbauelements 31, die der Emitterseite des IGBTs entspricht, sind mehrere Verbindungselemente 34 in Form von Aluminiumbändern aufgeschweißt. Jedes der Verbindungselemente 34 ist mit dem jeweils anderen Ende auf der Leiterbahn 26 verschweißt.

In FIG 3 ist eine Draufsicht auf die Oberseite 24 des Schaltungsträgers 5 gezeigt. Hieraus wird ersichtlich, dass drei Verbindungselemente 34 jeweils sowohl stromtechnisch als auch im Wesentlichen geometrisch parallel zueinander die Oberseite 33 mit der Leiterbahn 26 verbinden.

Für die aus Aluminium bestehenden Verbindungselemente 34 beträgt das flächenspezifische Schmelzintegral $J_S^2t$ = 23 000 $A^2s/(mm^2)^2$. Um GLG 6 zu erfüllen, muss der Stromtragquerschnitt $A_{min}$ somit mindestens einen Betrag von ca. 1,81 $mm^2$ haben.

Jedes der in FIG 1 bis 3 dargestellten Verbindungselemente 34 hat beispielsweise eine konstante Stärke s (FIG 2) von 0,5 mm und eine Breite b von 1,5 mm. Die drei Verbindungselemente 34 haben zusammen somit eine konstante Querschnittsfläche von 2,25 $mm^2$, die den Stromtragquerschnitt $A_{min}$ des Halbleitermoduls 2 darstellt.

Das absolute Schmelzintegral $I_S^2t$ hat somit nach GLG 2 einem Betrag von 116 438 $A^2S$, der dem 1,55-fachen des Durchlassintegrals $I_D^2t$ entspricht. Der Stromtragquerschnitt $A_{min}$ ist hier mit anderen Worten um einen Sicherheitsfaktor von F = 1,55 (gemäß GLG 7) überdimensioniert.

Jedes Verbindungselement 34 ist über eine Vielzahl von Kontaktflächen 40, deren jede durch eine distinkte Schweißstelle gebildet ist, auf der Oberseite 33 verschweißt. Die Kontaktflächen 40 sind dabei jeweils in Längsausdehnung jedes bandförmigen Verbindungselements 34 dicht aneinander gereiht. Hierdurch wird eine vergleichsweise hohe Packungsdichte der Kontaktflächen 40 auf der Oberseite 33 erreicht. In Summe nehmen die Kontaktflächen 40 hier beispielsweise mehr als 50% der Flächenausdehnung der Oberseite 33 ein.

Die auf jede der Kontaktflächen 40 im Kurzschlussfall wirkende Abhebekraft wird durch diese Dimensionierung der Kontaktflächen 40 soweit reduziert, dass diese Abhebekraft die Abreißkraft der an den Kontaktflächen 40 gebildeten Schweißverbindungen um mehr als einen Faktor 10 unterschreitet.

An seinem anderen Ende weist jedes Verbindungselement 34 eine einzelne Kontaktfläche 41 in Form einer Schweißverbindung auf, mit der das Verbindungselement stoffschlüssig und elektrisch leitend mit der Leiterbahn 26 verbunden ist.

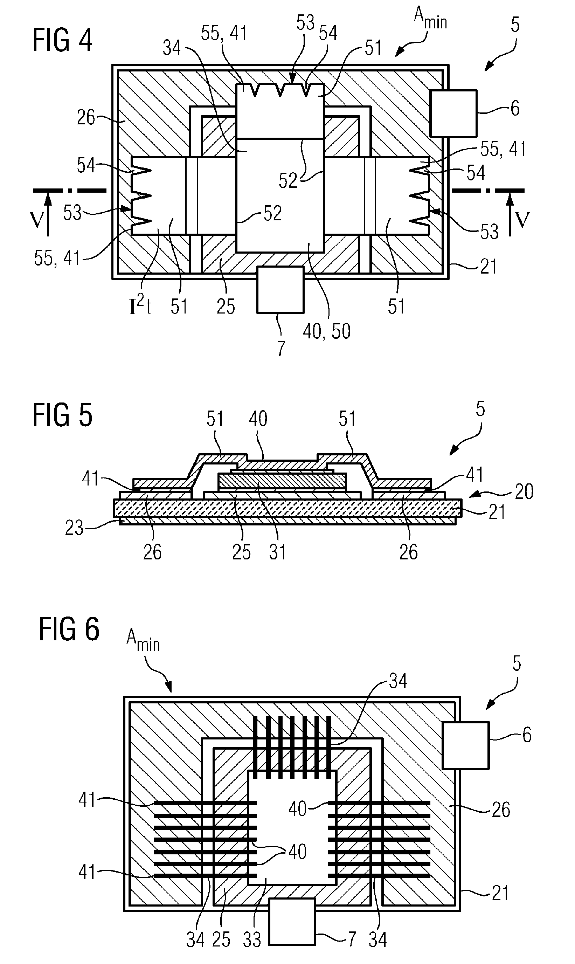

Die in FIG 4 und 5 gezeigte zweite Ausführungsform der Schalteinrichtung 5 unterscheidet sich von der vorstehend beschriebenen Ausführungsform dadurch, dass hier die Leiterbahn 26 die Leiterbahn 25 im Wesentlichen U-förmig umschließt. Ebenfalls im Unterschied zur ersten Ausführungsform weist die Schalteinrichtung 5 hier nur ein einziges Verbindungselement 34 auf, welches als Formteil aus Aluminiumblech gefertigt ist. Dieses umfasst eine Kontaktplatte 50, deren Form und Größe im Wesentlichen der Oberseite 33 des Halbleiterbauelements 31 entspricht, sowie drei Verbindungsarme 51, die sich jeweils einstückig an die Kontaktplatte 50 anschließen. Die Kontaktplatte 50 ist dabei unter Bildung der Kontaktfläche 40 (im Wesentlichen über ihre gesamte Fläche) mit der Oberseite 33 des Halbleiterbauelements 31 verlötet.

Die Verbindungsarme 51 stehen an drei aneinandergrenzenden (im Wesentlichen den von der Stromschiene 7 abgewandten) Seitenrändern 52 der Kontaktplatte 50 in drei entgegengesetzte Richtungen von dieser ab. Jeweils an dem von der Kontaktplatte 50 abgewandten Ende 53 des jeweiligen Verbindungsarmes 51 ist dieser optional durch endseitig eingebrachte Schlitze 54 in mehrere, hier z.B. vier, Kontaktfinger 55 unterteilt. Jeder Kontaktfinger 55 ist mittels einer der Kontaktflächen 41 auf der Leiterplatte 26 verlötet.

Die Verbindungsarme 51 sind hinsichtlich ihres jeweiligen, wiederum konstanten Querschnitts derart bemessen, das der aus der Summe dieser drei Querschnittsflächen gebildet Stromtragquerschnitt $A_{min}$ hinreichend groß ist, um GLG 6 zu erfüllen. Bevorzugt ist $A_{min}$ um einen Sicherheitsfaktor von etwa F = 1,5 gemäß GLG 7 überdimensioniert.

Alternativ dazu ist auch denkbar, das Verbindungselement 34 mit nur zwei, insbesondere diametral gegenüberliegenden und hinsichtlich ihres Querschnitts entsprechend ausgelegten Verbindungsarmen 51 auszubilden.

Zudem ist FIG 5 zu entnehmen, dass die Verbindungsarme 51 im Längsschnitt in etwa S-förmig ausgestaltet sind. Hierdurch erlangen die Verbindungsarme 51 eine federnde Eigenschaft. Biegt sich der Schaltungsträger 20 infolge von unterschiedlichen Wärmeausdehnungskoeffizienten seiner einzelnen Komponenten bei Temperaturschwankungen durch, so wird diese Biegung durch ein Federn der Verbindungsarme 51 kompensiert, so dass die Kontaktflächen 40, bzw. 41 weitestgehend vor mechanischer Belastung geschützt sind.

Die in FIG 6 dargestellte dritte Ausführungsform entspricht im Wesentlichen der zweiten Ausführungsform gemäß FIG 4 und 5. Im Unterschied zu den vorherigen Ausführungsbeispielen ist hier dem Halbleitermodul 2 im Rahmen der Schaltungsbaugruppe 1 ein Leistungsschutzschalter 3 mit einem Durchlassintegral $I_D{}^2 S$ von 50 000 $A^2 S$ vorgeschaltet. Zudem sind hier als Verbindungselemente 34 gemäß FIG 6 eine Anzahl von, hier z.B. 21, Bond-Drähten vorgesehen.

Jeder Bond-Draht hat beispielsweise einen Durchmesser von 0,3 mm, wodurch sich ein Stromtragquerschnitt $A_{min}$ von 1,48 mm$^2$ ergibt. Dies entspricht im Sinne von GLG 7 einem Sicherheitsfaktor F von 1,0.

Die Begriffe "Unterseite" und "Oberseite", sowie die damit korrespondierenden Begriffe "oben" und "unten" beziehen sich auf die in den FIG 1, 2 und 5 dargestellte Orientierung des Schaltungsträgers 20, und werden gemäß dieser Orientierung stets unabhängig von der jeweiligen Stellung des Schaltungsträgers im Raum verwendet. In diesem Sinne werden diese Richtungsangaben auch für die an dem Schaltungsträger 20 befestigten Komponenten verwendet.

**Patentansprüche**

1. Halbleitermodul (2)

   - mit einem Gehäuse (4),
   - mit einem darin aufgenommenen isolierenden Substrat (21),
   - mit mindestens einem Halbleiterbauelement (31), welches mit einer Unterseite (32) stoffschlüssig mit dem Substrat verbunden ist, sowie
   - mit mindestens einem elektrischen Verbindungselement (34), das zur elektrischen Kontaktierung stoffschlüssig und elektrisch leitend einerseits mit einer Oberseite (33) des Halbleiterbauelements (31) und andererseits mit einer Leiterbahn verbunden ist,
   - wobei die minimale Querschnittsfläche ($A_{min}$) des Verbindungselements (34) bzw. der Verbindungselemente (34) ausreichend groß dimensioniert ist, dass das Schmelzintegral ($I_S{}^2 t$) des Verbindungselements (34) bzw.

der Verbindungselemente (34) mindestens gleich groß ist, wie das Durchlassintegral ($I_D{}^2$t) einer dem Halbleitermodul (2) bestimmungsgemäß vorzuschaltenden Überstromschutzeinrichtung (3) .

2. Halbleitermodul (2) nach Anspruch 1, wobei eine durch die stoffschlüssige Verbindung gebildete Kontaktfläche (40, 41) des Verbindungselements (34) ausreichend groß dimensioniert ist, dass eine aus einer im Kurzschlussfall über die Kontaktfläche (40, 41) geleiteten maximalen Stromstärke resultierende Abhebekraft nicht ausreicht, das Verbindungselement (34) an der Kontaktfläche (40, 41) abzuheben.

3. Halbleitermodul (2) nach Anspruch 1 oder 2, wobei das Verbindungselement (34) eine Kontaktfläche (40) aufweist, mit der es stoffschlüssig im Wesentlichen mit der gesamten Oberseite (33) des Halbleiterbauelements (31) verbunden ist.

4. Halbleitermodul (2) nach Anspruch 1 oder 2, wobei das Verbindungselement (34) mehrere Kontaktflächen (40) aufweist, mit denen es jeweils stoffschlüssig mit der Oberseite (33) des Halbleiterbauelements (31) verbunden ist.

5. Halbleitermodul (2) nach einem der Ansprüche 1 bis 4, wobei das Verbindungselement (34) mehrere Kontaktflächen (40) aufweist, mit denen es jeweils stoffschlüssig mit der Leiterbahn (26) verbunden ist.

6. Halbleitermodul (2) nach einem der Ansprüche 1 bis 5, wobei das Verbindungselement (34) aus Aluminium, Gold, Kupfer oder im Wesentlichen aus einer Eisen-Nickel-Legierung gefertigt ist.

7. Halbleitermodul (2) nach einem der Ansprüche 1 bis 6, wobei das Verbindungselement (34) durch eine Lot-, eine Leitklebe-, eine Schweiß- oder eine Sinterverbindung stoffschlüssig mit der Oberseite (33) und / oder der zweiten Leiterbahn (26) verbunden ist.

8. Schaltungsbaugruppe (1)

   - mit einem Leistungsschutzschalter (3), sowie
   - mit einem Halbleitermodul (2)
   ○ mit einem Gehäuse (4),
   ○ mit einem darin aufgenommenen isolierenden Substrat (21),
   ○ mit mindestens einem Halbleiterbauelement (31), welches mit einer Unterseite (32) stoffschlüssig mit dem Substrat verbunden ist, sowie
   ○ mit mindestens einem elektrischen Verbindungselement (34), das zur elektrischen Kontaktierung stoffschlüssig und elektrisch leitend einerseits mit einer Oberseite (33) des Halbleiterbauelements (31) und andererseits mit einer Leiterbahn verbunden ist,
   ○ wobei die minimale Querschnittsfläche ($A_{min}$) des Verbindungselements (34) bzw. der Verbindungselemente (34) ausreichend groß dimensioniert ist, dass das Schmelzintegral ($I_S{}^2$t) des Verbindungselements (34) bzw. der Verbindungselemente (34) mindestens gleich groß ist, wie das Durchlassintegral ($I_D{}^2$t) des Leistungsschutzschalters (3).

FIG 1

$I$ 8  3  1  2  6

$I_D{}^2 t$

$I_K{}^2$

$I_D{}^2$  $t_A$  $t$  9

7  5  4

FIG 2

7  30  33  31  32  24  34  41  5  6

25

21  22  23  20  26  $s$

FIG 3

5  21  25  31  33  40  34  $A_{min}$  $J_S{}^2 t$  41  26

7  $b$  6

40  34  $J_S{}^2 t$  41

EP 2 230 689 A1

FIG 4

FIG 5

FIG 6

Europäisches
Patentamt

European
Patent Office

Office européen
des brevets

**EUROPÄISCHER RECHERCHENBERICHT**

Nummer der Anmeldung

EP 09 15 5617

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 197 52 196 C1 (SIEMENS AG [DE]) 11. Februar 1999 (1999-02-11) | 1,2,5-7 | INV. H01L23/62 |
| Y | * Spalte 1 - Spalte 4; Abbildung 3a * ----- | 8 | H01L23/373 H01L25/07 |
| X | US 2006/249831 A1 (CONNAH NORMAN G [GB] CONNAH NORMAN GLYN [GB]) 9. November 2006 (2006-11-09) * Abbildung 6 * ----- | 1,3,4,6 | |
| Y | DORIN O. NEACSU: "Power-Switching Converters: Medium and High Power" 25. Mai 2006 (2006-05-25), CRC , XP002533474 | 8 | |
| A | * Seite 159 - Seite 161 * ----- | 1-7 | |
| A | US 2006/043610 A1 (MAIER JOSEF [DE]) 2. März 2006 (2006-03-02) * das ganze Dokument * ----- | 1-8 | |
| | | | RECHERCHIERTE SACHGEBIETE (IPC) H01L |

Der vorliegende Recherchenbericht wurde für alle Patentansprüche erstellt

| Recherchenort | Abschlußdatum der Recherche | Prüfer |
|---|---|---|
| München | 23. Juni 2009 | Manook, Rhoda |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 09 15 5617

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-06-2009

| Im Recherchenbericht angeführtes Patentdokument | Datum der Veröffentlichung | Mitglied(er) der Patentfamilie | Datum der Veröffentlichung |
|---|---|---|---|
| DE 19752196 C1 | 11-02-1999 | WO 9927554 A1<br>EP 1034555 A1<br>JP 2001524735 T | 03-06-1999<br>13-09-2000<br>04-12-2001 |
| US 2006249831 A1 | 09-11-2006 | KEINE | |
| US 2006043610 A1 | 02-03-2006 | KEINE | |

EPO FORM P0461